# EUROPEAN PATENT SPECIFICATION

(11) **EP 2 265 103 B1**
(45) Date of publication and mention of the grant of the patent: **25.05.2011**
(21) Application number: 09425351.5
(22) Date of filing: 11.09.2009
(51) Int. Cl.: H05K 7/20

(54) **Container for electric and/or electronic equipment provided with heat dissipation means and frequency converter housed in said container.**
Behälter für elektrische und/oder elektronische Ausrüstung mit Vorrichtung zur Wärmeableitung, und Frequenzumsetzer untergebracht in besagtem Behälter.
Récipient pour le matériel électrique et/ou électronique avec moyen de dissipation de la chaleur, et convertisseur de moyens et de fréquence logé dans ledit récipient.

(43) Date of publication of application: 22.12.2010
(73) Proprietor: CALPEDA S.p.A., I-36050 Montorso Vicentino (VI) (IT)
(72) Inventor: Rosa, Massimo, 36071 Arzignano (VI) (IT); Cailotto, Mariano, 36071 Arzignano (VI) (IT)
(74) Representative: Bonini, Ercole

(56) References cited:
- EP-A- 1 843 476
- DE-U1- 20 205 305
- US-A1- 2001 054 494

## Description

The present invention concerns a container for electric/electronic equipment provided with means for dissipating the heat produced by said equipment during operation.

In particular, the container that is the subject of the invention is used to contain equipment consisting of frequency converters, usually known as inverters, that, as is known, during their operation produce a large amount of heat that must be dissipated.

The invention concerns also a frequency converter housed in said container.

It is known that to operate electric motors at variable rpm these are fed by means of special electronic devices called frequency converters, commonly known as inverters, that substantially have the function to vary the frequency and voltage with which the motor is fed.

The need to operate electric motors at variable rpm arises in many industrial and civil applications, for example in liquid pumping systems in general, when pumps should operate at variable rpm.

In fact, if pumps operate at variable rpm three important advantages are substantially obtained, which can be summed up as follows
- constant pressure in the system downstream of the pumps;
- high energy savings, as a motor operating at variable rpm absorbs less energy than a motor operating at fixed speed;
- possibility to use pressurized tanks with limited capacity while at the same time guaranteeing the same performance levels offered by systems in which large tanks are used.

In order to make the electric motors that set the pumps rotating operate at variable rpm, the former are fed by the already mentioned frequency converters or inverters that are substantially electronic devices that receive constant power supply in terms of voltage and frequency (for example 230 Volts at 50 Hz from the power mains) and deliver modified voltage and frequency, capable of varying the rotation speed of the electric motor.

During operation the inverter, which is housed into a container, generates a large amount of heat that must be rapidly dissipated in order to guarantee the correct operation of the inverter itself.

A known method for dissipating the heat produced by the inverter consists in favouring the spontaneous circulation of air through fins provided on the container that houses the inverter.

The drawback posed by these construction forms lies in that in some operating conditions the degree of cooling guaranteed by the fins may be insufficient. According to another known method for dissipating the heat produced, forced ventilation is provided through fans installed in the container of the inverter, another solution, for inverters installed on motors, exploits the air flow produced by the fan of the motor fed by the inverter.

This cooling method, though certainly being more effective than the one just described, however poses the drawback of being more complex and more expensive to carry out.

Another known method is shown in DE 26205305U. A heat sink for a CPU has a tube with internal fins and a fan blowing air over the fins. The tube has a base attached to it with a planar surface for thermal contact with the CPU.

According to a further known method for dissipating the heat produced, to cool the inverter it is possible to use the same liquid pumped in by the pump that is set rotating by the motor fed by the same inverter.

For this purpose, in the container housing the inverter there is an exchange chamber provided with an inlet fitting and an outlet fitting that are connected in series to one of the pipes of the hydraulic system.

In this way the pumped liquid that circulates in the system flows also through the exchange chamber, taking heat away from the inverter.

Even this last solution, however, poses a series of acknowledged drawbacks. A first drawback lies in that, as the inverter is housed in the same container where there is also the heat exchange chamber, in case of malfunction or failure of the inverter it is necessary to dismantle the whole equipment.

This is clearly a nuisance to the user, who is forced to intervene also on the hydraulic part of the system, since in order to remove the container together with the inverter housed therein it is necessary to remove also the fittings that connect it to the pipe.

Another drawback is represented by the damage that the system and the electric equipment can suffer if the pumped liquid flows from the heat exchange chamber into the area of the container where the inverter is housed. Another, yet not the least drawback is represented by the cost, which is clearly higher than the cost of any container with heat dissipator described up to now. The present invention intends to overcome all the limitations and drawbacks described above.

In particular, it is a first object of the invention to provide a container for electric equipment provided with heat dissipation means that is easy and quick to install on and remove from the system using the electric equipment housed therein.

It is a further object of the invention to provide a container that can be installed and removed, together with the electric equipment housed therein, with no need to intervene through the installation and/or removal of parts of the system using said electric equipment.

It is another object of the invention to provide a container with which it is possible to dissipate variable quantities of heat by replacing some of its constituent parts.

It is a further object of the invention to provide a container whose construction costs are lower than those of equivalent containers of known type.

It is another object of the invention to provide a container that guarantees for the equipment housed therein at least the same degree of heat dissipation guaranteed by the containers of known type.

It is another yet not the least object of the invention to provide a container that guarantees for the equipment housed therein at least the same electrical protection guaranteed by the containers of known type.

The objects described above are achieved by a container provided with a heat dissipator and having the characteristics illustrated in the main claim, to which the reader should refer for the sake of brevity.

Other characteristics of the invention are illustrated in the dependent claims. The objects described above will be highlighted in greater detail here below, with reference to the attached drawings, wherein:
- Figure 1 shows a front axonometric view of the container that is the subject of the invention once installed;
- Figure 2 shows a front exploded view of the container shown in Figure 1;

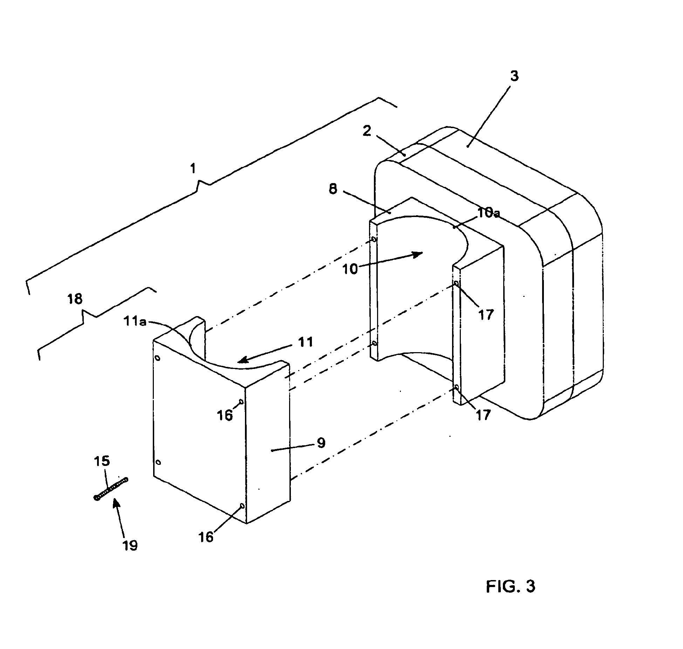

- Figure 3 shows a rear exploded view of the container shown in Figure 1;
- Figure 4 shows a rear exploded view of a construction variant of the container of the invention;
- Figure 5 shows a rear exploded view of another construction variant of the container of the invention.

The container for electric and/or electronic equipment that is the subject of the invention is represented in Figures from 1 to 3, where it is indicated as a whole by **1**.

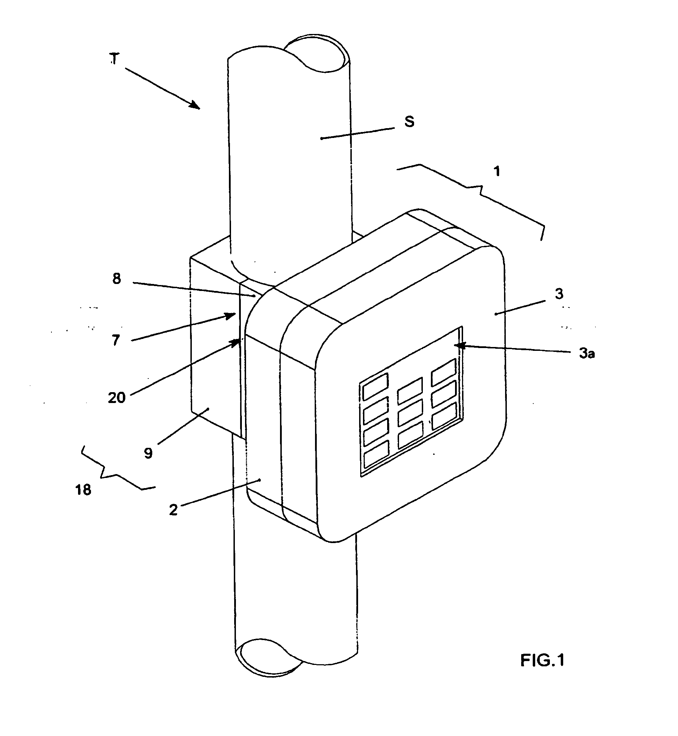

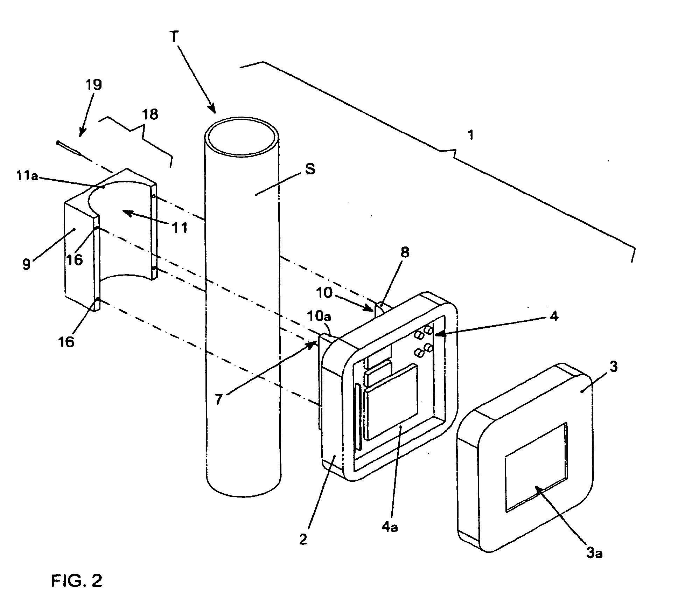

With particular reference to Figures 1 and 2, in which it is shown installed and in a front exploded view, respectively, it can be observed that it comprises a casing **2**, closed by a cover **3**, which houses an electric and/or electronic piece of equipment **4**.

The cover **3** is provided with an opening **3a** suited to allow the displays and controls used for operating the equipment to be seen and accessed from the outside.

There are also means for dissipating the heat produced by the equipment **4** during operation, indicated as a whole by **7**.

According to the invention, the dissipation means **7** comprise at least one flange 8 belonging to the container **1**, provided with a concave part **10** whose profile **10a** can be matched with the external surface S of a pipe T in which a fluid circulates, to which it can be removably connected via connection means **18**.

The connection means **18** can be of any type, for example one or more clamps fastened around the pipe **T** and connected to the flange **8** by means of screws. In the construction form described herein the connection means **18** preferably comprise a counterflange **9** that can be opposed to the corresponding flange 8, provided with a concave part **11** whose profile **11a** can be matched with the external surface S of the same pipe **T** on the opposite side of the flange 8, wherein the flange 8 and the counterflange **9** can be connected to each other through locking means **19**.

In this way the heat dissipation means **7** constituted by the flange **8** also serve as means for fixing the container **1,** in cooperation with the counterflange **9**. The electric and/or electronic equipment **4** housed in the container **1**, and more precisely in the casing 2 that makes it up, can be of any type.

In particular, the container 1 of the invention is used to house electronic equipment consisting of frequency converters, commonly known as inverters, which in turn are used to feed electric motors and operate them at variable speeds.

In the case described herein the container **1** of the invention houses an inverter **4a** for feeding an electric motor that sets rotating the hydraulic pump of a liquid distribution system, in particular water for civil or industrial use.

The system comprises the pipe **T** to which the inverter **4a** is connected, said inverter being cooled by the water circulated in the system by the pump connected to the electric motor fed by the same inverter **4a**.

The pipe **T** to which the dissipation means **7** of the container **1** housing the inverter **4a** are connected is preferably the pump's delivery pipe, where the fluid at lower temperature that ensures optimal heat exchange and dissipation circulates.

For this purpose it should be noted that the profiles **10a**, **11a** of the concave parts **10**, **11** of the flange **8** and counterflange **9** are shaped as arcs of a circle, so that they can be externally coupled with the pipe **T**.

Obviously, the radius of curvature of the above mentioned arcs of a circle will vary depending on the diameter of the pipe **T** with which they are coupled.

It is obvious, however, that the profiles of the concave parts of the flanges can also have different shapes, provided that they are such as to match the profile of the corresponding pipe.

As can be observed in Figure 2, the flange **8** forms a single body with the container **1**, and in particular it makes up a single body with the casing **2** to which the inverter **4a** is fixed, said inverter **4a** being suited to transfer by conduction to the flange **8** the heat it generates during its operation.

The casing **2** and the flange **8** are therefore made of a material with optimal heat conductivity in order to dissipate the greatest possible amount of heat towards the pipe **T** and the liquid flowing therein in the shortest possible time. Therefore the casing **2** and the flange **8** will be preferably, even if not necessarily, made of die cast aluminium.

Obviously the casing **2** and the flange **8** will be sized according to the size of the inverter **4,** to the diameter of the pipe **T** and to the amount of heat to be dissipated.

The connection between the flange **8** and the second flange **9** is carried out via locking means **19** that comprise screws **15** inserted in through holes **16** made in the counterflange **9** and screwed into blind threaded holes **17** made in the flange **8.**

If, as shown in Figure 1, the flange **8** should come into contact with the counterflange **9** at the level of the common contact surfaces **20**, also the counterflange **9** would contribute to the dissipation of heat.

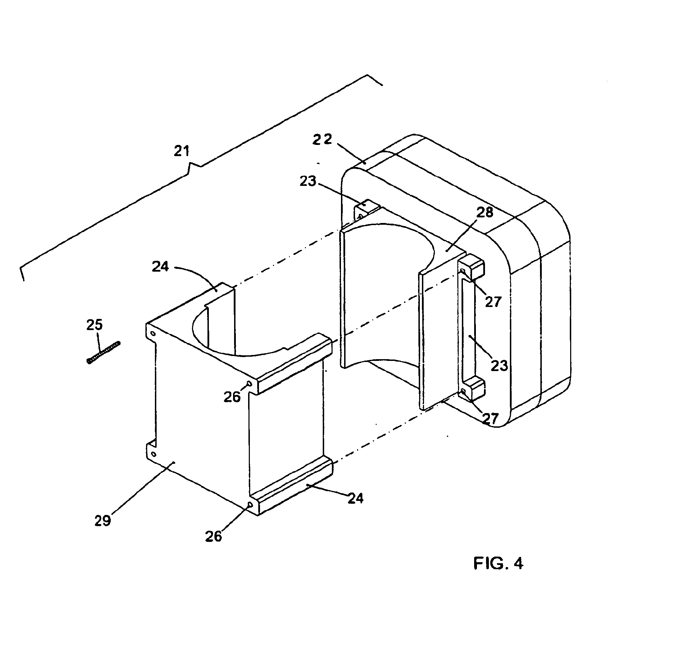

According to an embodiment of the invention shown in Figure 4, the container of the invention, indicated as a whole by **21**, has the casing **22** provided with first projections **23** arranged at the sides of the flange **28**, in which there are blind threaded holes **27** that house the locking means comprising screws **25** inserted in the through holes **26** made in second projections **24** provided at the sides of the counterflange **29**.

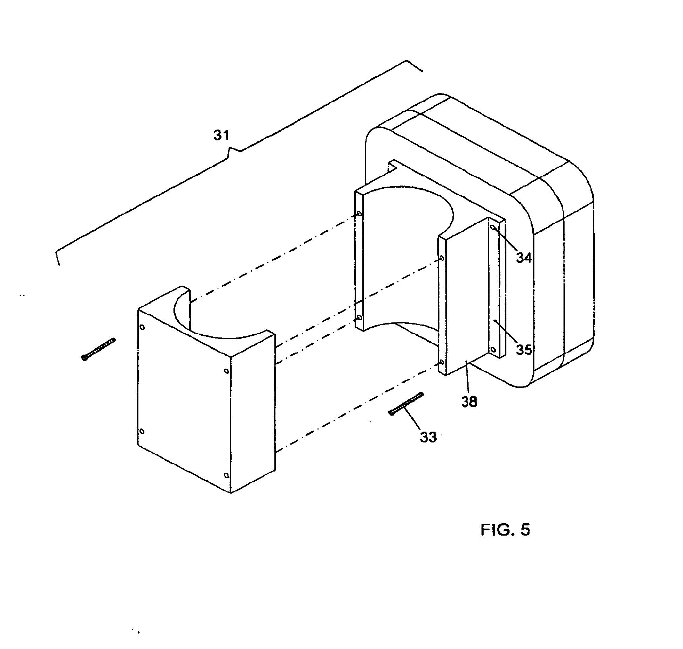

According to a further construction variant shown in Figure 5, the container of the invention, indicated as a whole by **31**, differs from the construction variant described above with reference to Figures from 1 to 3 owing to the fact that in this case the flange **38** can be separated from the casing **32**, to which it is connected through fixing screws **33**.

These, as can be observed, are inserted in through holes **34** made in lateral projections **35** of the flange **38** and are screwed into corresponding blind threaded holes made in the casing **32**.

This last construction variant is particularly useful if the user intends to vary the amount of heat to be dissipated. In fact, by increasing the size of the flange **38** it is possible to modify the amount of heat that is transmitted to the pipe **T** and to the fluid flowing therein.

It is clear that embodiments different from the ones described can be carried out, in which the flanges can have shapes different from the ones illustrated and described herein, if necessary in order to couple them with two or more pipes arranged side by side or with pipes having sections that are not circular. The materials used to make the container, or at least the part in contact with the inverter and the flange, must feature an optimal heat conductivity coefficient.

Furthermore, the container may be carried out in any shape, even if not illustrated and described herein.

In the construction phase, further embodiments may be carried out which, although not represented or described herein, must all be considered protected by the present patent, provided that they fall within the scope of the following claims.

Where technical features mentioned in any claim are followed by reference signs, those reference sings have been included for the sole purpose of increasing the intelligibility of the claims and accordingly such reference signs do not have any limiting effect on the interpretation of each element identified by way of example by such reference signs.

## Claims

1. Container (1, 21, 31) for electric and/or electronic equipment (4, 4a) comprising:
- a casing (2, 22, 32) that houses at least one of said pieces of equipment (4, 4a);
- a cover (3) for closing said casing (2, 22, 32);
- at least one opening (3a) made in said cover in order to ensure access from the outside to control and/or display devices connected to said equipment (4, 4a);
- means (7) for dissipating the heat produced by said equipment (4, 4a) during operation,
**characterized in that** said dissipation means (7) comprise at least one flange (8, 28, 38) belonging to said container (1, 21, 31) provided with a concave part (10) whose profile (10a) can be matched with the external surface (S) of a pipe (T) in which a fluid circulates and to which it can be removably connected via connection means (18).

2. Container (1, 21, 31) according to claim 1), **characterized in that** said connection means (18) comprise a counterflange (9) that can be opposed to the corresponding flange (8), provided with a concave part (11) whose profile (11 a) can be matched with said external surface (S) of said pipe (T) on the side opposite said flange (8), wherein said flange (8) and said counterflange (9) can be connected to each other via locking means (19).

3. Container (1, 21) according to claim 1) or 2), **characterized in that** said at least one flange (8, 28) forms a single body with said casing (2, 22) of said container (1, 21).

4. Container (31) according to claim 1) or 2), **characterized in that** said at least one flange (38) can be separated from said casing (32) of said container (31) to which it is removably connected via fixing means (33).

5. Container (1, 21, 31) according to claim 2), **characterized in that** said locking means (19) are screws (15, 25).

6. Container (1, 31) according to claim 5), **characterized in that** said screws (15) are inserted in through holes (16) made in said counterflange (9, 39) and are screwed into blind threaded holes (17) made in said flange (8, 38).

7. Container (21) according to claim 5), **characterized in that** said screws (25) are inserted in through holes (26) made in said counterflange (29) and are screwed into blind threaded holes (27) made in first projections (23) provided on said casing (22) at the side of said flange (28).

8. Container (21) according to claim 7), **characterized in that** said through holes (26) are made in second projections (24) provided at the side of said counterflange (28).

9. Container (31) according to claim 3), **characterized in that** said fixing means are screws (33) inserted in through holes (34) made in lateral projections (35) of said flange (38) and screwed into blind threaded holes made in said casing (32).

10. Container (1, 21, 31) according to any one of the preceding claims, **characterized in that** said profiles (10a, 11a) of said concave parts (10, 11) of said flanges (8, 28, 38) and of said counterflanges (9, 29, 39) are arcs of a circle.

11. Container (1, 21, 31) according to any one of the preceding claims, **characterized in that** said electric and/or electronic equipment (4) comprise at least one frequency converter (4a).

12. Frequency converter (4a) housed in a container (1, 21, 31) according to any one of the preceding claims of the type comprising:
- a casing (2, 22, 32) that houses said frequency converter (4a);
- a cover (3) for closing said casing (2, 22, 32);
- at least one opening (3a) made in said cover (3) in order to ensure access from the outside to control and/or display devices connected to said frequency converter (4a);
- means (7) for dissipating the heat produced by said frequency converter (4a) during operation,
**characterized in that** said dissipation means (7) comprise at least one flange (8, 28, 38) belonging to said container (1, 21, 31) provided with a concave part (10) whose profile (10a) can be matched with the external surface (S) of a pipe (T) to which it can be removably connected via connection means (18).

## Patentansprüche

1. Behälter (1, 21, 31) für elektrische und/oder elektronische Geräte (4, 4a), Folgendes umfassend:
- ein Gehäuse (2, 22, 32), das wenigstens eines der besagten Geräte (4, 4a) aufnimmt;
- einen Deckel (3) zum Verschließen des besagten Gehäuses (2, 22, 32);
- wenigstens eine Öffnung (3a) in besagtem Deckel zur Gewährleistung des Zugangs von außen zu an dem besagten Gerät (4, 4a) angeschlossenen Steuer- und/oder Anzeigevorrichtungen;
- Mittel (7) zur Dissipation der durch das besagte Gerät (4, 4a) während des Betriebs erzeugten Wärme,
**dadurch gekennzeichnet, dass** besagte Dissipationsmittel (7) wenigstens einen zu besagtem Behälter (1, 21, 31) gehörigen Flansch (8, 28, 38) umfassen, der einen konkaven Teil (10) aufweist, dessen Profil (10a) mit der Außenfläche (S) eines Rohrs (T) zusammenfügbar ist, in dem eine Flüssigkeit zirkuliert, und an das er mit Verbindungsmitteln (18) abnehmbar fixiert werden kann.

2. Behälter (1, 21, 31) gemäß Patentanspruch 1), **dadurch gekennzeichnet, dass** die besagten Verbindungsmittel (18) einen dem entsprechenden Flansch (8) entgegensetzbaren Gegenflansch (9) umfassen, der einen konkaven Teil (11) aufweist, dessen Profil (11a) mit der besagten Außenfläche (S) des besagten Rohrs (T) an der dem besagten Flansch (8) gegenüberliegenden Seite zusammenfügbar ist, wobei der besagte Flansch (8) und der besagte Gegenflansch (9) mit Befestigungsmitteln (19) miteinander verbunden werden können.

3. Behälter (1, 21) gemäß Patentanspruch 1) oder 2), **dadurch gekennzeichnet, dass** der besagte wenigstens eine Flansch (8, 28) einen einzigen Körper mit dem Gehäuse (2, 22) des besagten Behälters (1, 21) bildet.

4. Behälter (31) gemäß Patentanspruch 1) oder 2), **dadurch gekennzeichnet, dass** der besagte wenigstens eine Flansch (38) vom besagten Gehäuse (32) des besagten Behälters (31), an dem er abnehmbar mit Befestigungsmitteln (33) verbunden ist, abgetrennt werden kann.

5. Behälter (1, 21, 31) gemäß Patentanspruch 2), **dadurch gekennzeichnet, dass** die besagten Befestigungsmittel (19) Schrauben (15, 25) sind.

6. Behälter (1, 31) gemäß Patentanspruch 5), **dadurch gekennzeichnet, dass** die besagten Schrauben (15) in Durchgangsbohrungen (16) in besagtem Gegenflansch (9, 39) eingesteckt sind und in Blind-Gewindebohrungen (17) in besagtem Flansch (8, 38). eingeschraubt sind.

7. Behälter (21) gemäß Patentanspruch 5), **dadurch gekennzeichnet, dass** die besagten Schrauben (25) in Durchgangsbohrungen (26) in besagtem Gegenflansch (29) eingesteckt sind und in Blind-Gewindebohrungen (27) eingeschraubt sind, welche sich in ersten Vorsprüngen (23) seitlich von besagtem Flansch (28) an besagtem Gehäuse (22) befinden.

8. Behälter (21) gemäß Patentanspruch 7), **dadurch gekennzeichnet, dass** die besagten Durchgangsbohrungen (26) in zweiten Vorsprüngen (24) ausgeführt sind, die sich seitlich vom besagten Gegenflansch (28) befinden.

9. Behälter (31) gemäß Patentanspruch 3), **dadurch gekennzeichnet, dass** die besagten Befestigungsmittel Schrauben (33) sind, die in Durchgangsbohrungen (34) in seitlichen Vorsprüngen (35) des besagten Flansches (38) eingesteckt und in Blind-Gewindebohrungen im besagten Gehäuse (32) eingeschraubt sind.

10. Behälter (1, 21, 31) gemäß eines jeglichen der vorstehenden Patentansprüche, **dadurch gekennzeichnet, dass** die besagten Profile (10a, 11a) der besagten konkaven Teile (10, 11) der besagten Flansche (8, 28, 38) und der besagten Gegenflansche (9, 29, 39) Kreisbögen sind.

11. Behälter (1, 21, 31) gemäß eines jeglichen der vorstehenden Patentansprüche, **dadurch gekennzeichnet, dass** die besagten elektrischen und/oder elektronischen Geräte (4) wenigstens einen Frequenzwandler (4a) umfassen.

12. Frequenzwandler (4a) in einem Behälter (1, 21, 31) gemäß eines jeglichen der vorstehenden Patentansprüche aufgenommen, von dem Typ, der Folgendes umfasst:
- ein Gehäuse (2, 22, 32), das den besagten Frequenzwandler (4a) aufnimmt;
- einen Deckel (3) zum Schließen des besagten Gehäuses (2, 22, 32);
- wenigstens eine Öffnung (3a) in dem besagten Deckel (3) zur Gewährleistung des Zugangs von außen zu an dem besagten Frequenzwandler (4a) angeschlossenen Steuer- und/oder Anzeigevorrichtungen;
- Mittel (7) zur Dissipation der durch den besagten Frequenzwandler (4a) während des Betriebs erzeugten Wärme,
**dadurch gekennzeichnet, dass** die besagten Dissipationsmittel (7) wenigstens einen zu besagtem Behälter (1, 21, 31) gehörigen Flansch (8, 28, 38) umfassen, der einen konkaven Teil (10) aufweist, dessen Profil (10a) mit der Außenfläche (S) eines Rohrs (T) zusammenfügbar ist, an das er mit Verbindungsmitteln (18) abnehmbar fixiert werden kann.

## Revendications

1. Conteneur (1, 21, 31) pour appareils électroniques (4, 4a) comprenant:
- une enveloppe (2, 22, 32) logeant au moins un desdits appareils (4, 4a);
- un couvercle (3) pour la fermeture dudit conteneur (2, 22, 32);
- au moins une ouverture (3a) réalisée sur ledit couvercle afin de pouvoir garantir l'accès de l'extérieur à des dispositifs de contrôle et/ou de visualisation reliés auxdits appareils (4, 4a);
- des moyens (7) de dissipation de la chaleur produite par lesdits appareils (4, 4a) durant le fonctionnement,
**caractérisé en ce que** lesdits moyens de dissipation (7) comprennent au moins une bride (8, 28, 38) appartenant audit conteneur (1, 21, 31) dotée d'une partie concave (10) dont le profil (10a) peut être uni avec la surface extérieure (S) d'un tuyau (T) dans lequel un fluide circule et auquel elle peut être reliée de manière amovible par des moyens de connexion (18).

2. Conteneur (1, 21, 31) selon la revendication 1), **caractérisé en ce que** lesdits moyens de connexion (18) comprennent une contre-bride (9) qui peut s'opposer à la bride correspondante (8), dotée d'une partie concave (11) dont le profil (11a) peut être uni avec la surface extérieure (S) dudit tuyau (T) sur le côté opposé à ladite bride (8), où ladite bride (8) et ladite contre-bride (9) peuvent être reliées entre elles par des moyens de blocage (19).

3. Conteneur (1, 21) selon la revendication 1) ou 2), **caractérisé en ce que** ladite au moins une bride (8, 28) forme un corps unique avec ladite enveloppe (2, 22) dudit conteneur (1,21).

4. Conteneur (31) selon la revendication 1) ou 2), **caractérisé en ce que** ladite au moins une bride (38) peut être séparée de ladite enveloppe (32) dudit conteneur (31) à laquelle elle est reliée de manière amovible par des moyens de fixation (33).

5. Conteneur (1, 21, 31) selon la revendication 2), **caractérisé en ce que** lesdits moyens de blocage (19) sont des vis (15, 25).

6. Conteneur (1, 31) selon la revendication 5), **caractérisé en ce que** lesdites vis (15) sont insérées dans des trous passants (16) réalisés dans ladite contre-bride (9, 39) et sont vissées dans des trous borgnes filetés (17) réalisés dans ladite bride (8, 38).

7. Conteneur (21) selon la revendication 5), **caractérisé en ce que** lesdites vis (25) sont insérées dans des trous passants (26) réalisés dans ladite contre-bride (29) et sont vissées dans des trous borgnes filetés (27) réalisés dans de premières saillies (23) prévues sur ladite enveloppe (22) latéralement à ladite bride (28).

8. Conteneur (21) selon la revendication 7), **caractérisé en ce que** lesdits trous passants (26) sont réalisés dans de deuxièmes saillies (24) prévues latéralement à ladite contre-bride (28).

9. Conteneur (31) selon la revendication 3), **caractérisé en ce que** lesdits moyens de fixation sont des vis (33) insérées dans des trous passants (34) réalisés dans des saillies latérales (35) de ladite bride (38) et vissées dans des trous borgnes filetés réalisés dans ladite enveloppe (32).

10. Conteneur (1, 21, 31) selon l'une quelconque des revendications précédentes, **caractérisé en ce que** lesdits profils (10a, 11a) desdites parties concaves (10, 11) desdites brides (8, 28, 38) et desdites contre-brides (9, 29, 39) sont des arcs d'un cercle.

11. Conteneur (1, 21, 31) selon l'une quelconque des revendications précédentes, **caractérisé en ce que** lesdits appareils électriques et/ou électroniques (4) comprennent au moins un convertisseur de fréquence (4a).

12. Convertisseur de fréquence (4a) logé da un conteneur (1, 21, 31) selon l'une quelconque des revendications précédentes, du type comprenant:
- une enveloppe (2, 22, 32) apte à loger ledit convertisseur de fréquence (4a);
- un couvercle (3) apte à fermer ladite enveloppe (2, 22, 32);
- au moins une ouverture (3a) réalisée sur ledit couvercle (3) apte à garantir l'accès de l'extérieur à des dispositifs de contrôle et/ou de visualisation réliés audit convertisseur de fréquence (4a);
- des moyens (7) pour la dissipation de la chaleur produite par ledit convertisseur de fréquence (4a) durant le fonctionnement,
**caractérisé en ce que** lesdits moyens de dissipation (7) comprennent au moins une bride (8, 28, 38) appartenant audit conteneur (1, 21, 31) dotée d'une partie concave (10) dont le profil (10a) peut être uni avec la surface extérieure (S) d'un tuyau (T) auquel elle peut être reliée de manière amovible par des moyens de connexion (18).
